# EUROPEAN PATENT APPLICATION

(11) **EP 1 690 912 A1**
(43) Date of publication of application: **16.08.2006**
(21) Application number: 04799645.9
(22) Date of filing: 05.11.2004
(51) Int. Cl.: C09K 11/06, H05B 33/14

(54) **ORGANIC ELECTROLUMINESCENT DEVICE AND DISPLAY**

(30) Priority: 07.11.2003 JP 2003377905; 31.08.2004 JP 2004252263; 29.10.2004 JP 2004315487
(71) Applicant: SONY CORPORATION, Tokyo 141-0001 (JP)
(72) Inventor: UEDA, Naoyuki. c/o SONY CORPORATION, Shinagawa-ku, Tokyo (JP); TAKADA, Ichinori. c/o SONY CORPORATION, Shinagawa-ku, Tokyo (JP)
(74) Representative: Müller - Hoffmann & Partner
(86) International application number: PCT/JP2004/016794
(87) International publication number: WO 2005/044942

(57) **Abstract**

An organic electroluminescent element is **characterized by** having a light emitting layer (503) containing a fluoranthene derivative and emitting green light. The fluoranthene derivative is introduced as a guest into the light emitting layer, and, by using an organic material having a fluorescence spectrum overlapping the absorption spectrum of the fluoranthene derivative, e.g., an arylanthracene derivative as a host, the organic electroluminescent element advantageously emits green light with satisfactorily excellent light emission efficiency and high color purity and has higher reliability.

## Description

### Technical Field

The present invention relates to an organic electroluminescent element and a display apparatus. More particularly, the present invention is concerned with an organic electroluminescent element emitting green light and a display apparatus using the same.

### Background Art

In 1987, Tang et. al. of Eastman Kodak Company presented an organic thin-film electroluminescent element of a stacked structure having an amorphous light-emitting layer which can be driven at a low voltage and emit light with a high luminance, and since then, studies and development have been vigorously made on a display apparatus using an organic electroluminescent element as a substitute for a cathode-ray tube (CRT). The organic electroluminescent element is a display element of a self-emitting type having a light emitting layer which is composed of an organic material and which is sandwiched between an anode and a cathode, and a display apparatus using the organic electroluminescent element enables flat panel display to work with low power consumption.

In such a display apparatus, for realizing full color display, the use of light emitting materials of three primary colors (red, green, and blue) having high light emission efficiency and high color purity as well as high reliability is indispensable. Of the light emitting materials of three colors, the green light emitting material has been studied the most thoroughly since the above-mentioned presentation of Tang et. al., and various methods shown below for improving the light emission efficiency of the material have been proposed.

For example, a structure of an element having a light emitting layer using a light emitting material composed of a coumarin derivative, a quinacridone derivative, or a pyran derivative as a guest material (dopant) added to Alq3 as a host material has been proposed {see J. Appl. Phys. (1989), vol. 65, p. 3,610}. With respect to the element of a structure having a light emitting layer comprised of Alq3 doped with DMQA (N,N'-dimethylquinacridone), it has been reported that a light emission efficiency of 6 to 8 Cd/A and a half-life of 7,000 to 8,000 h (initial luminance: about 1,400 Cd/m²) are achieved {see Appl. Phys. Lett. (1997), vol. 70, p. 1,665}.

A phosphorescence element having a light emitting layer using an iridium (Ir) complex as a dopant has been proposed {see Appl. Phys. Lett. (1999), vol. 75, p. 5}. Specifically, as a dopant and a host, the combination of Ir(ppy)₃ {tris[2-(2-pyridinyl)phenyl-C,N]-iridium; tris(2-phenylpyridine)iridium (III)} and CBP {4,4'-bis(carbazol-9-yl) biphenyl} has been widely studied, and a light emission efficiency as very high as 20 to 40 Cd/A has been reported, and it has been reported that a light emission efficiency of 19 Cd/A and a half-life of 4,000 h (initial luminance: 1,000 Cd/m²) are achieved {see Appl. Phys. Lett. (2002), vol. 81, p. 162}.

Furthermore, an element using an arylamine compound has been disclosed, and a light emission efficiency of about 2 to 6 Cd/A and a half-life of 700 h at best (initial luminance: 300 Cd/m²) have been reported (see Japanese Patent Application Publication No. HEI8-199162).

A fluoranthene compound and an element using the same have been disclosed (see Japanese Patent Application Publication Nos. HEI10-189247 and 2002-69044).

The organic electroluminescent elements having the above-mentioned constructions, however, cannot achieve a half-life of 10,000 hours or longer (initial luminance: 1,000 to 1,500 Cd/m²) which is required for realizing a display apparatus, and are not satisfactory in both the light emission efficiency and the reliability.

Accordingly, a task of the present invention is to provide an organic electroluminescent element emitting green light, which is advantageous not only in that it has both satisfactorily excellent light emission efficiency and high color purity, but also in that it has higher reliability, and a display apparatus using the organic electroluminescent element.

### Disclosure of the Invention

The organic electroluminescent element of the present invention for attaining the above task is characterized in that it is a green light emitting element having a light emitting layer sandwiched between an anode and a cathode, wherein the light emitting layer comprises a fluoranthene derivative represented by the following general formula (1):

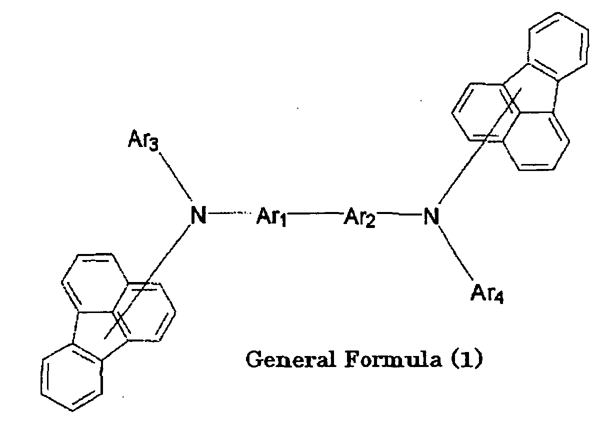

In the general formula (1) above, each of two fluoranthenes may be independently substituted with hydrogen, an alkyl group (including a cycloalkyl group) having 1 to 6 carbon atoms, an alkoxy group having 1 to 6 carbon atoms, or an aryl group having 6 to 12 carbon atoms.

In the general formula (1), each of Ar₁ and Ar₂ independently represents an arylene group having 6 to 22 carbon atoms.

In the general formula (1), each of Ar₃ and Ar₄ independently represents an aryl group having 6 to 16 carbon atoms.

In each aryl group and each arylene group, one hydrogen or a plurality of hydrogens may be replaced by an alkyl group (including a cycloalkyl group) or alkoxy group having 1 to 6 carbon atoms.

As an example of the fluoranthene derivative of the general formula (1) above, there can be mentioned a fluoranthene derivative represented by the following general formula (2):

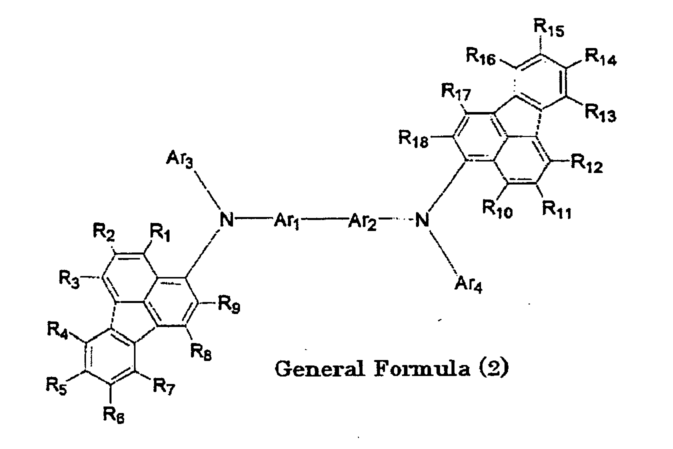

In the general formula (2) above, each of substituents R₁ to R₁₈ in two fluoranthenes independently represents hydrogen, an alkyl group (including a cycloalkyl group) having 1 to 6 carbon atoms, an alkoxy group having 1 to 6 carbon atoms, or an aryl group having 6 to 12 carbon atoms. With respect to the fluoranthene derivative of the general formula (1) above, the bonding site of the fluoranthene to nitrogen is not limited to the bonding site shown in the general formula (2).

As a specific example of the fluoranthene derivative represented by the general formula (1) above, there can be mentioned a compound represented by the structural formula (F1) below corresponding to the general formula (2) above wherein the arylene groups Ar₁ and Ar₂ are phenylene groups and the aryl groups Ar₃ and Ar₄ are phenyl groups. Further, there can be mentioned compounds represented by the structural formulae (F2) to (F4) below corresponding to the structural formula (F1) wherein each of the phenyl groups Ar₃ and Ar₄ is substituted with a methyl group. Each of the phenyl groups Ar₃ and Ar₄ may be substituted with two or more alkyl groups or alkoxy groups having 6 carbon atoms or less (e.g., a methyl group).

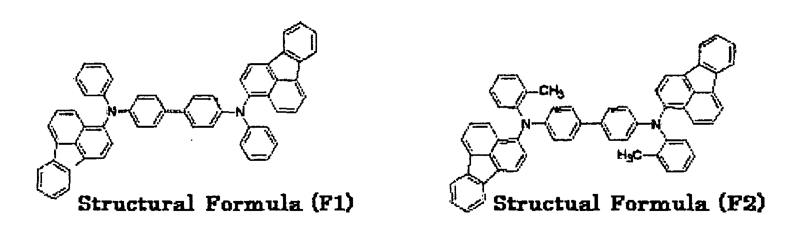

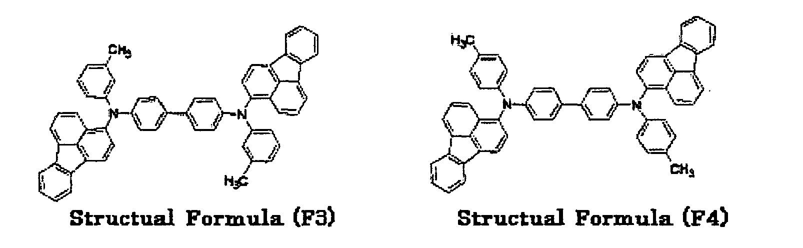

As shown in the structural formulae (F5) to (F9) below, each of Ar₃ and Ar₄ in the general formula (1) may be independently a fused-ring aromatic hydrocarbon group which is an aryl group having 16 carbon atoms or less (preferably having 14 carbon atoms or less). The aryl groups Ar₃ and Ar₄ include a biphenyl group as an aryl group having 16 carbon atoms or less (preferably having 14 carbon atoms or less). The biphenyl group may have either a structure, as shown in the structural formula (F9) below, such that the terminal phenyl group is bonded at the ortho-position or a structure such that the terminal phenyl group is bonded at the meta-position or para-position.

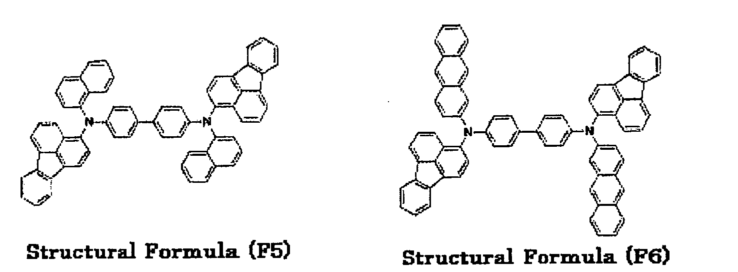

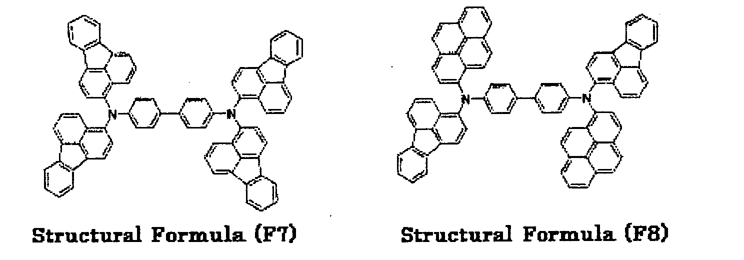

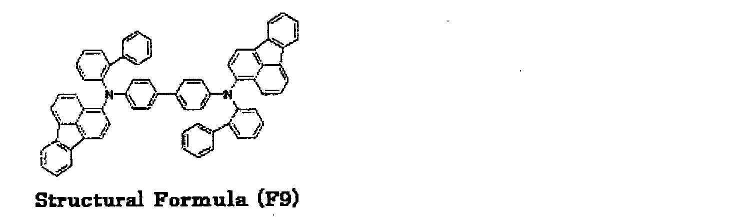

Further, as shown in the structural formulae (F10) to (F12) below, each of the arylene groups Ar₁ and Ar₂ and aryl groups Ar₃ and Ar₄ in the general formula (1) may be substituted with an alkyl group having 6 carbon atoms or less. Each of the arylene groups Ar₁ and Ar₂ and aryl groups Ar₃ and Ar₄ may be substituted with an alkoxy group having 6 carbon atoms or less. Each of the arylene groups Ar₁ and Ar₂ and aryl groups Ar₃ and Ar₄ may be substituted with two or more above groups.

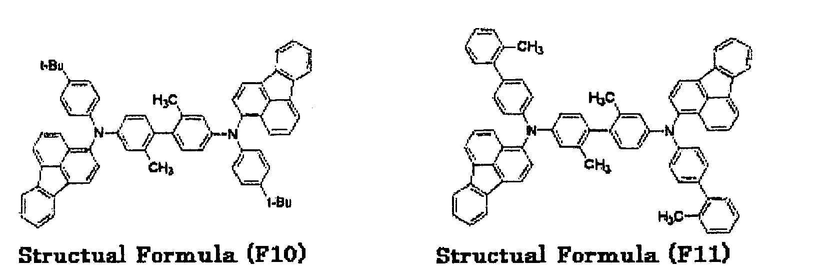

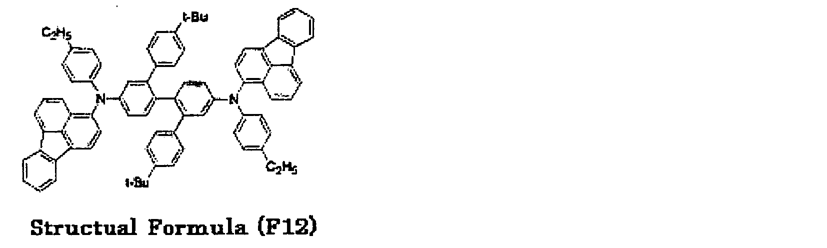

As other specific examples of the fluoranthene derivatives represented by the general formula (1) above, there can be mentioned compounds represented by the structural formulae (F13) and (F14) below, in which each of two fluoranthenes is substituted with an alkyl group having 6 carbon atoms or less or an aryl group having 12 carbon atoms or less. Each of two fluoranthenes may be substituted with an alkoxy group having 6 carbon atoms or less. Particularly as shown in the structural formula (F14) below, when each of two fluoranthenes is substituted with aryl groups, each of the aryl groups may be substituted with an alkyl group (or an alkoxy group) having 6 carbon atoms or less.

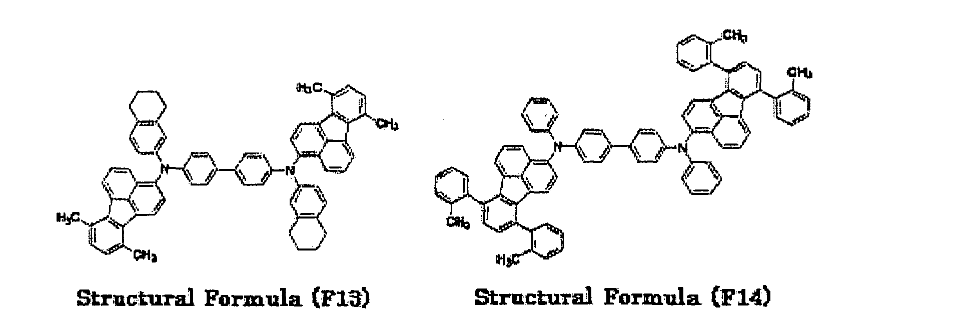

As further specific examples of the fluoranthene derivatives represented by the general formula (1) above, there can be mentioned compounds represented by the structural formulae (F15) to (F20) below, in which each of the arylene groups Ar₁ and Ar₂ is a fused-ring aromatic hydrocarbon group having 22 carbon atoms or less (preferably having 16 carbon atoms or less).

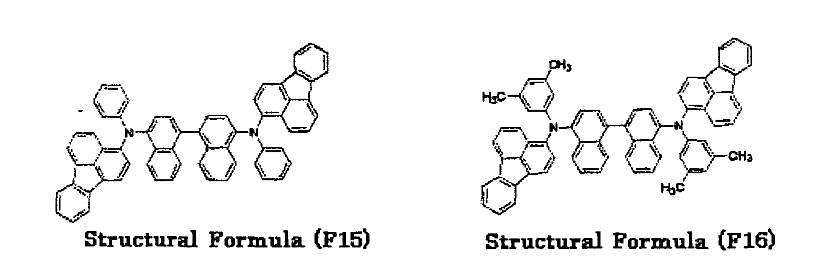

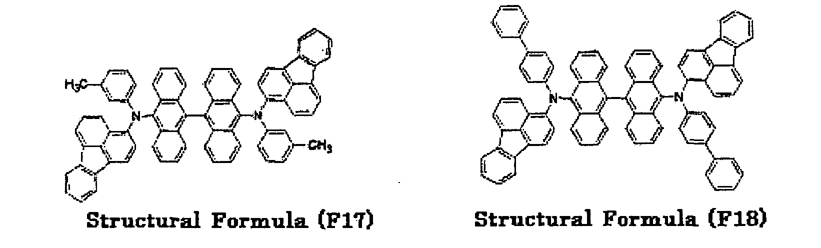

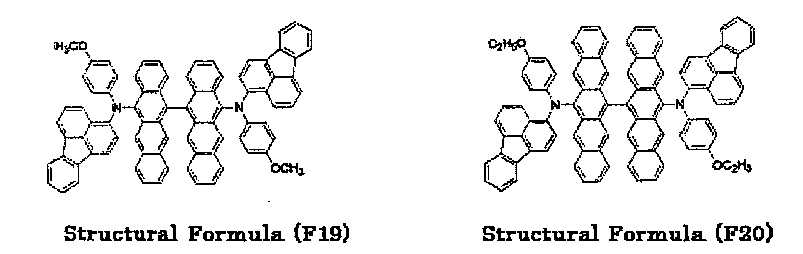

With respect to the fluoranthene derivative of the general formula (1) above, the bonding site of the fluoranthene to nitrogen is not limited to the bonding site shown in the structural formulae (F1) to (F20) above, and may be, e.g., the bonding site shown in the structural formula (F21) below or another. The two fluoranthenes may be individually bonded to nitrogen at different bonding sites.

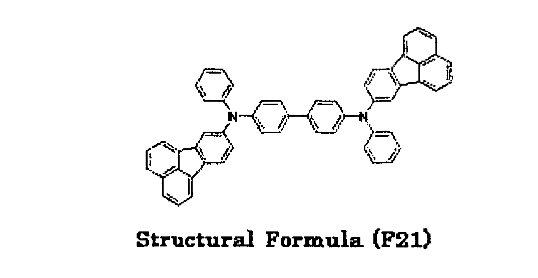

The structure of the fluoranthene derivative contained in the light emitting layer in the organic electroluminescent element of the present invention is not limited to the structures represented by the structural formulae (F1) to (F21) above, and may be any structure which satisfies the general formula (1) above, and, for example, in the general formula (1), Ar₁ and Ar₂, or Ar₃ and Ar₄ may be different groups. In the general formula (1), the substituents in two fluoranthenes may be different from one another.

In the organic electroluminescent element having a light emitting layer having the above-described construction, by virtue of containing the fluoranthene derivative represented by the general formula (1) above in the light emitting layer, light emission in the green wave range with high initial luminance and low attenuation rate can be achieved.

In the fluoranthene derivative of the general formula (1) above, especially in the specific examples having the structural formulae (F1) to (F21), as mentioned above, each of Ar₁ and Ar₂ in the general formula (1) is preferably an arylene group having 6 to 14 carbon atoms. Each of Ar₃ and Ar₄ is preferably an aryl group having 6 to 14 carbon atoms. Specifically, it is preferred that each of the aryl group and arylene group in the fluoranthene derivative represented by the general formula (1) is derived from any one of benzene, naphthalene, anthracene, and biphenyl.

By restricting the number of carbon atoms and the size of the conjugated ring in Ar₁, Ar₂, Ar₃, and Ar₄ in the general formula (1), the wave range of light emission is prevented from being narrowed or widened. Particularly, by restricting the number of carbon atoms in Ar₃ and Ar₄, the wave range of light emission is prevented from being narrowed due to the strain of the whole molecule represented by the general formula (1). Thus, light emission in the green wave range with high color purity can be achieved.

The fluoranthene derivative having the above-described construction is introduced into the light emitting layer in an amount of less than 50% by volume, i.e., as a guest.

The light emitting layer having the fluoranthene derivative contains an organic material having a fluorescence spectrum overlapping the absorption spectrum of the fluoranthene derivative. The fluorescence spectrum of the organic material preferably more largely overlaps the absorption spectrum of the fluoranthene derivative, and, in such a case, the energy of the fluorescence spectrum of the organic material easily moves to the fluoranthene derivative, thus improving the light emission efficiency. The organic material is composed of an arylanthracene derivative represented by the following general formula (3):

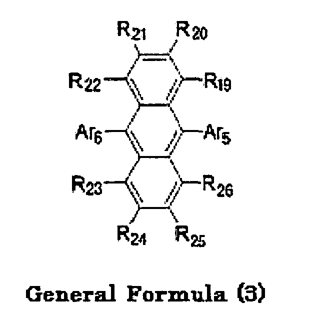

In the general formula (3) above, each of R₁₉ to R₂₆ independently represents hydrogen, or an alkyl group (including a cycloalkyl group) or alkoxy group having 1 to 6 carbon atoms.

In the general formula (3) above, each of Ar₅ and Ar₆ independently represents an aryl group or ring assembly aryl group having 6 to 60 carbon atoms. The aryl group or ring assembly aryl group may have one hydrogen or a plurality of hydrogens replaced by an alkyl group (including a cycloalkyl group) or alkoxy group having 1 to 12 carbon atoms, or a substituted or unsubstituted ethenyl group having 60 carbon atoms or less. The substituted ethenyl group is a group corresponding to the ethenyl group in which part of or all of the hydrogens are replaced by a hydrocarbon group, such as an alkyl group or an aryl group, and may have 60 carbon atoms or less in total.

Specific examples of the arylanthracene derivatives are shown in the structural formulae (A1) to (A13) below.

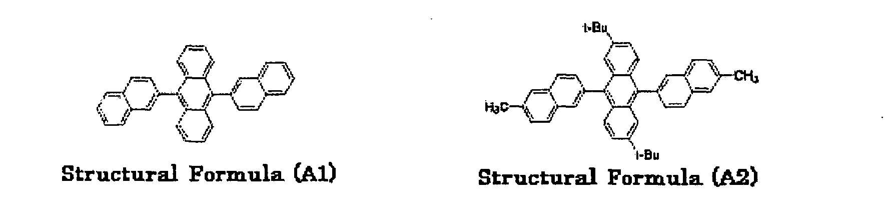

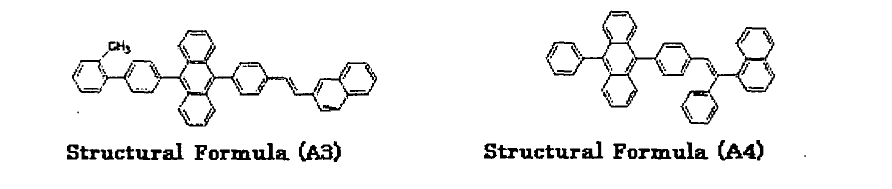

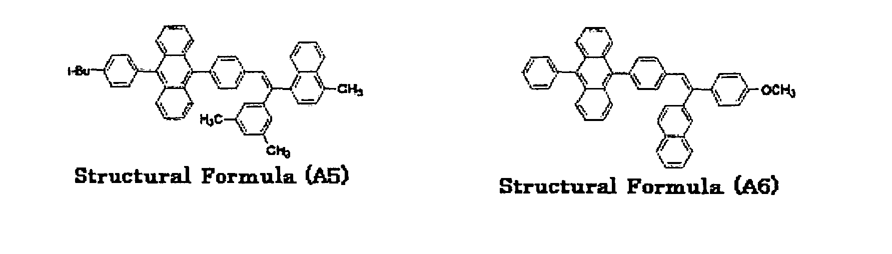

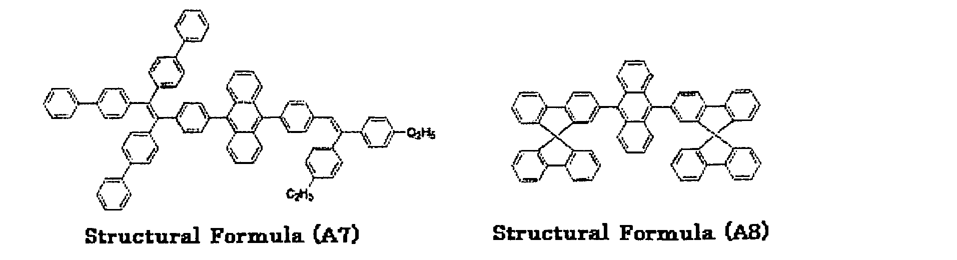

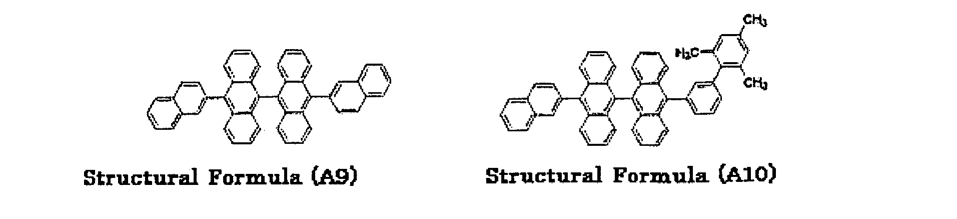

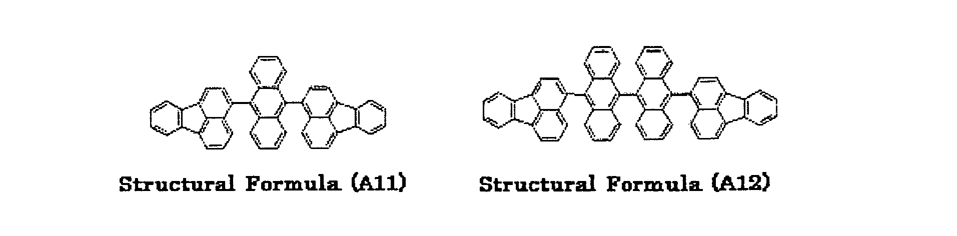

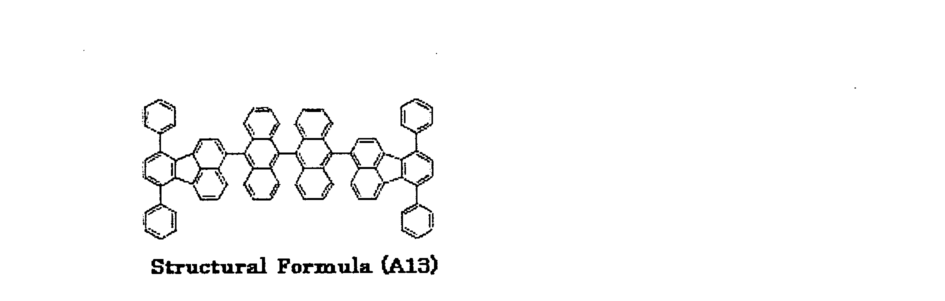

The structure of the arylanthracene derivative contained in the light emitting layer in the organic electroluminescent element of the present invention is not limited to the structures represented by the structural formulae (A1) to (A13) above, and may be any structure which satisfies the general formula (3) above.

The present invention is also directed to a display apparatus which comprises a plurality of organic electroluminescent elements having the above-described light emitting layer sandwiched between an anode and a cathode and being arranged on a substrate.

In the display apparatus, the organic electroluminescent element having high luminance and high color purity as well as low attenuation rate as mentioned above is used as a green light emitting element to constitute the display apparatus, and this element and a red light emitting element as well as a blue light emitting element are used in combination, enabling full color display with high color reproduction.

As mentioned above, by virtue of containing the fluoranthene derivative represented by the general formula (1) above in the light emitting layer, the organic electroluminescent element of the present invention is advantageous not only in that it has high color purity and excellent light emission efficiency, but also in that it has high initial luminance and low attenuation rate, thus making it possible to achieve light emission in the green wave range with high reliability.

In the display apparatus of the present invention, the organic electroluminescent element having high color purity and high light emission efficiency as well as high reliability as mentioned above as a green light emitting element, a red light emitting element, and a blue light emitting element are used to constitute one pixel, enabling full color display with high color reproduction.

### Brief Description of Drawings

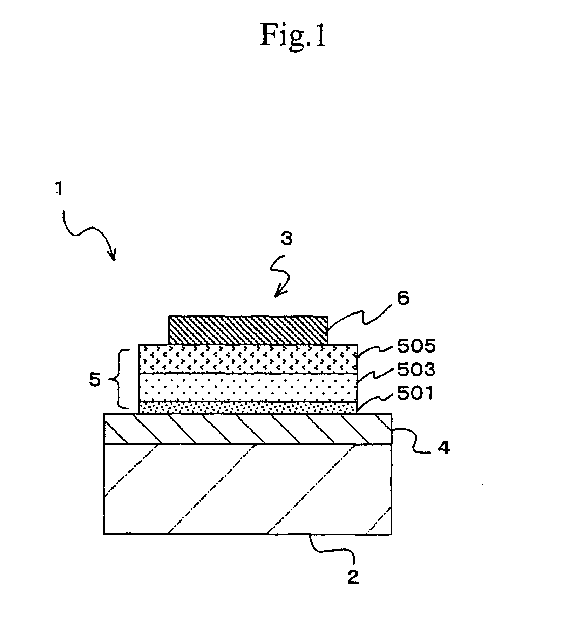

FIG. 1 is a cross-sectional view of the essential portion of the construction of the organic electroluminescent element and display apparatus according to an embodiment.

### Best Mode for Carrying Out the Invention

Hereinbelow, the construction of the organic electroluminescent element of the present invention and a display apparatus using the same will be described in detail with reference to the accompanying drawing. FIG. 1 is a diagrammatic cross-sectional view of the organic electroluminescent element of the present invention and a display apparatus using the same.

A display apparatus 1 shown in the figure comprises a substrate 2, and an organic electroluminescent element 3 formed on the substrate 2. The organic electroluminescent element 3 comprises a bottom electrode 4, an organic layer 5, and a top electrode 6, which are stacked in this order on the substrate 2, and has a construction such that the light emits outwards from the substrate 2 side or top electrode 6 side. In the figure, a structure is shown in which the organic electroluminescent element 3 is formed as one pixel on the substrate 2, but the display apparatus 1 comprises a plurality of pixels wherein a plurality of organic electroluminescent elements 3 are arranged in each pixel.

Next, the constructions of individual parts constituting the display apparatus 1 are described in detail in the order of the substrate 2, the bottom electrode 4 and top electrode 6, and the organic layer 5.

The substrate 2 is composed of a glass, silicon, or plastic substrate, or a TFT (thin film transistor) substrate having a TFT formed thereon, and, especially when the display apparatus 1 is of a transmission type such that the light emits outwards from the substrate 2 side, the substrate 2 is composed of a material having light transmission properties.

The bottom electrode 4 formed on the substrate 2 is used as an anode or a cathode. In the figure, a representative example is shown in which the bottom electrode 4 serves as an anode.

The bottom electrode 4 is appropriately patterned into a form according to the driving system of the display apparatus 1. For example, when the display apparatus 1 is driven in a passive matrix system, the bottom electrode 4 is patterned into, e.g., stripes. On the other hand, when the display apparatus 1 is driven in an active matrix system in which a TFT is formed per pixel, the bottom electrode 4 is patterned according to each of the pixels arranged, and connected to the TFT formed in each pixel through a contact hole (not shown) formed in the interlayer dielectric film covering the TFT.

On the other hand, the top electrode 6 formed on the bottom electrode 4 through the organic layer 5 is used as a cathode when the bottom electrode 4 serves as an anode, or is used as an anode when the bottom electrode 4 serves as a cathode. In the figure, an example is shown in which the top electrode 6 serves as a cathode.

When the display apparatus 1 is of a passive matrix system, the top electrode 6 is patterned into, e.g., stripes crossing the stripes of the bottom electrode 4, and the intersection where they cross corresponds to the organic electroluminescent element 3. On the other hand, when the display apparatus 1 is of an active matrix system, the top electrode 6 is formed into a continuous film covering the surface of the substrate 2, and is used as an electrode common to the pixels. When an active matrix system is employed as a driving system of the display apparatus 1, for securing the opening ratio of the organic electroluminescent element 3, it is desired that the display apparatus is of a top emission type such that the light emits outwards from the top electrode 6 side.

As an anode material constituting the bottom electrode 4 (or top electrode 6), one having a work function as large as possible is preferred, and, for example, nickel, silver, gold, platinum, palladium, selenium, rhodium, ruthenium, iridium, rhenium, tungsten, molybdenum, chromium, tantalum, niobium, an alloy or oxide thereof, tin oxide, ITO, zinc oxide, or titanium oxide is preferred.

On the other hand, as a cathode material constituting the top electrode 6 (or bottom electrode 4), one having a work function as small as possible is preferred, and, for example, magnesium, calcium, indium, lithium, aluminum, silver, or an alloy thereof is preferred.

As a material for the electrode from which the light generated by the organic electroluminescent element 3 emits outwards, a material having light transmission properties is appropriately selected from the materials listed above, and a material having a light transmittance of
30% or more in the emission wave range of the organic
electroluminescent element 3 is especially preferably used.

For example, when the display apparatus 1 is of a transmission type such that the light emits outwards from the substrate 2 side, an anode material having light transmission properties, such as ITO, is used in the bottom electrode 4 as an anode and a cathode material having a high reflectance, such as aluminum, is used in the top electrode 6 as a cathode.

On the other hand, when the display apparatus 1 is of a top emission type such that the light emits outwards from the top electrode 6 side, an anode material, such as chromium or a silver alloy, is used in the bottom electrode 4 as an anode and a cathode material having light transmission properties, such as an alloy of magnesium and silver (MgAg), is used in the top electrode 6 as a cathode. It is preferred to design the thickness of the top electrode 6 so that the light transmittance becomes about 30% in the green wave range and the resonance structure is optimized between the below-described organic layer 5 and the bottom electrode 4 to enhance the intensity of the light emitted.

The organic layer 5 sandwiched between the bottom electrode 4 and the top electrode 6 comprises a hole transport layer 501, a light emitting layer 503, and an electron transport layer 505, which are stacked in this order from the anode side (bottom electrode 4 side as viewed in the figure).

In the hole transport layer 501, a known material, such as a triphenylamine dimer, trimer, or tetramer, or a star-burst amine, e.g., NPB {N,N'-di(naphthalen-l-yl)-N,N'-diphenylbenzidine} or TPTE {N,N'-diphenyl-N,N'-bis[N-(4-methylphenyl)-N-phenyl-(4-aminophenyl)]-1 ,1'-biphenyl-4,4'-diamine} can be used in the form of a single layer, a stacked layer, or a mixture.

The light emitting layer 503 formed on the hole transport layer 501 is a characteristic layer in the present invention, and contains, as a guest, the fluoranthene derivative described above using the general formula (1) and structural formulae (F1) to (F21).

The fluoranthene derivative has high hole transport properties. For this reason, when the concentration of the fluoranthene derivative in the light emitting layer is as high as 50% by volume or more, light emission from the below-described electron transport layer 505 is observed, lowering the light emission efficiency of the light emitting layer 503. Therefore, the fluoranthene derivative is introduced as a guest into the light emitting layer 503, and the concentration of the fluoranthene derivative in the light emitting layer 503 is desirably 1 to less than 50% by volume, preferably 1 to 20% by volume, further preferably 1 to 10% by volume.

The light emitting layer 503 contains, in addition to the above-described fluoranthene derivative, as a host, an organic material having a fluorescence spectrum overlapping the absorption spectrum of the fluoranthene derivative, i.e., the arylanthracene derivative described above using the general formula (3) and structural formulae (A1) to (A13).

In the electron transport layer 505 formed on the light emitting layer 503, a known material, such as Alq3, oxydiazole, triazole, benzimidazole, or a silole derivative, can be used.

In the above-mentioned construction, a not shown hole injection layer may be formed between the bottom electrode 4 as an anode and the hole transport layer 501. In the hole injection layer, a conductive polymer, such as PPV (polyphenylene vinylene), or a known material, such as copper phthalocyanine, a star-burst amine, or a triphenylamine dimer, trimer, or tetramer, can be used in the form of a single layer, a stacked layer, or a mixture. The hole injection layer is more preferably formed since the hole injection efficiency is improved.

A not shown electron injection layer may be formed between the electron transport layer 505 and the cathode (top electrode 6). In the electron injection layer, an alkali metal oxide, an alkali metal halide, an alkali earth metal oxide, or an alkali earth metal halide, such as lithium oxide, lithium fluoride, cesium iodide, or strontium fluoride, can be used. The electron injection layer is more preferably formed since the electron injection efficiency is improved.

In the formation of the organic layer 5 having a stacked structure having the materials described above, an organic material synthesized by a known method and a known method of vacuum deposition or spin coating can be used.

In the display apparatus 1 having the organic electroluminescent element 3 having the above-described construction, for preventing the organic electroluminescent element 3 from deteriorating due to moisture or oxygen in the air, it is desired that a not shown sealing film composed of magnesium fluoride or silicon nitride (SiNₓ) is formed on the substrate 2 so that it covers the organic electroluminescent element 3, or a not shown sealing casing is put over the organic electroluminescent element 3 and the hollow portion is filled with dried inert gas or in a vacuum.

In the display apparatus 1 having the organic electroluminescent element 3 having the above-described construction, full color display may be conducted in a way such that the organic electroluminescent element 3 as a green light emitting element and a not shown red light emitting element and a not shown blue light emitting element are formed in the respective pixels, which three pixels constitute a subpixel, i.e., one set of pixels, and a plurality of subpixels are arranged on the substrate 2.

By virtue of containing the fluoranthene derivative represented by the general formula (1) above and the arylanthracene derivative represented by the general formula (3) above in the light emitting layer 503, the organic electroluminescent element 3 having the above-described construction can achieve light emission in the green wave range, which is advantageous not only in that the light emission efficiency is high and the attenuation rate is low, but also in that the reliability is high and the color purity is excellent. In the display apparatus 1 having the organic electroluminescent element 3, the organic electroluminescent element 3 and a red light emitting organic electroluminescent element as well as a blue light emitting organic electroluminescent element are used in combination, enabling full color display with high color reproduction.

### Examples

Hereinbelow, specific Examples 1 to 14 of the present invention, Comparative Examples 1 to 3, and the results of evaluation of the organic electroluminescent elements produced in the Examples and Comparative Examples will be described.

### Example 1

A glass substrate (ITO substrate) having an ITO transparent electrode (anode) having a thickness of 190 nm was subjected to ultrasonic cleaning using a neutral detergent, acetone, and ethanol. The ITO substrate was dried, and then subjected to UV/ozone treatment for 10 minutes. Then, the ITO substrate was fixed to the substrate holder of a deposition machine and then the pressure in a deposition chamber was reduced to 1.4 x 10⁻⁴ Pa.

N,N'-Diphenyl-N,N'-bis[4'-{N,N-bis(naphtha-1-yl)amino}-biphenil-4-yl]benzidine was first deposited on the ITO transparent electrode at a deposition rate of 0.2 nm/sec so that the deposited film had a thickness of 65 nm to form a hole injection transport layer. Then, 9,10-di-(2-naphthyl)anthracene (ADN) represented by the structural formula (A1) above as a host composed of an arylanthracene derivative and N,N'-di(3-fluoranthenyl)-N,N'-di(3-phenyl)benzidine represented by the structural formula (F1) above as a guest composed of a fluoranthene derivative were codeposited from the respective deposition sources at a total deposition rate of about 0.2 nm/sec so that the codeposited film had a thickness of 35 nm to form a light emitting layer having a guest concentration of 5% by volume. Then, Alq3 was deposited at a deposition rate of 0.2 nm/sec so that the deposited film had a thickness of 15 nm to form an electron transport layer. Lithium fluoride (LiF) was deposited on the electron transport layer so that the deposited film had a thickness of 0.1 nm, and further magnesium and silver were codeposited (atomic ratio: 95:5) from the respective deposition sources at a total deposition rate of about 0.4 nm/sec so that the codeposited film had a thickness of 70 nm to form a cathode. Thus, an organic electroluminescent element of a bottom emission type such that the light emits outwards from the substrate side was produced.

### Examples 2 to 4

Organic electroluminescent elements of a bottom emission type were individually produced in accordance with substantially the same procedure as in Example 1 except that the concentration of the guest composed of the fluoranthene derivative of the structural formula (F1) in the light emitting layer was changed to those shown in the Table 1 below, i.e., 10% by volume (Example 2), 20% by volume (Example 3), or 40% by volume (Example 4).

**Table 1**

| | Guest concentration | Host | Luminance (Cd/m²) | Chromaticity | ELₘₐₓ (nm) | Voltage (V) | Light emission efficiency (Cd/A) | Power efficiency (lm/W) | Attenuation rate after 100 h |
|---|---|---|---|---|---|---|---|---|---|
| Example 1 | Structural formula (F1):5% | Structural formula(Al) | 2,210 | (0.358, 0.598) | 532 | 5.33 | 17.68 | 10.42 | 10% |
| Example 2 | Ditto: 10% | Ditto | 1,940 | (0.397,0.590) | 537 | 4.83 | 15.52 | 10.11 | 14% |
| Examples 3 | Ditto:20% | Ditto | 1,570 | (0.393,0.583) | 539 | 4.56 | 12.56 | 8.66 | 14% |
| Example 4 | Ditto:40% | Ditto | 1,090 | (0.411,0.570) | 544 | 4.56 | 8.72 | 6.01 | 18% |
| Comparative Example 1 | Coumarin 6: 1% | Alq3 | 1;225 | (0.275, 0.605) | 523 | 5.70 | 9.80 | 5.40 | 25% |
| Comparative Example2 2 | Structural formula (F1): 5% | Ditto | 1,230 | (0.437,0.541) | 554 | 5.34 | 9.84 | 5.79 | 6% |
| | | | | | | | | | |
| Example5 5 | Resonance structure in Example 1 | | 2,580 | (0.285, 0.677) | 533 | 4.96 | 20.60 | 13.10 | *9% |
| Comparative Example 3 | Resonance structure in Comparative Example 1 | | 1,780 | (0.250, 0.680) | 525 | 5.00 | 14.10 | 8.84 | *23% |

| | | | | | | | | | |
|---|---|---|---|---|---|---|---|---|---|
| * The value in each of Example 5 and Comparative Example 3 is an attenuation rate after 1,000 hours. | | | | | | | | | |

### Comparative Example 1

An organic electroluminescent element of a transmission type was produced in accordance with substantially the same procedure as in Example 1 except that, instead of the guest composed of the fluoranthene derivative of the structural formula (F1) in the light emitting layer, coumarin 6:3-(2-benzothiazolyl)-7-diethylaminocoumarin was used, and that, instead of the host composed of the arylanthracene derivative (ADN) of the structural formula (A1) in the light emitting layer, Alq3 was used. The guest concentration was 1% by volume.

### Comparative Example 2

An organic electroluminescent element of a transmission type was produced in accordance with substantially the same procedure as in Example 1 except that, instead of the host composed of the arylanthracene derivative of the structural formula (A1) in the light emitting layer, Alq3 was used. The guest concentration was 5% by volume.

### Results of evaluation

With respect to each of the organic electroluminescent elements of a transmission type produced in Examples 1 to 4 and Comparative Examples 1 and 2, evaluation was made as follows. Each element was driven with a direct current at 12.5 mA/cm² to measure light emission properties. Further, an attenuation rate was measured after the element was continuously driven at 12.5 mA/cm² in a nitrogen gas atmosphere for 100 hours. The results are shown in the Table 1 above.

As can be seen from the results shown in Table 1, in the organic electroluminescent element in Example 1 in which the light emitting layer is composed of the fluoranthene derivative {structural formula (F1)} and the arylanthracene derivative (ADN){structural formula (A1)}, green light emission at a luminance of 2,210 Cd/m² was confirmed upon driving with a direct current at a current density of 12.5 mA/cm². The driving voltage was 5.33 V, the light emission efficiency was 17.68 Cd/A, and the power efficiency was 10.42 lm/W. The attenuation rate of the luminance after continuously driving the element at a current density of 12.5 mA/cm² in a nitrogen gas stream for 100 hours was 10%. The chromaticity was (0.358, 0.598), which is particularly close to the standard of sRGB green light emission, i.e., (0.300, 0.600), indicating that green with high purity was obtained.

In the organic electroluminescent elements in Examples 2 to 4 in which the light emitting layer is composed of the similar materials, the larger the concentration of the fluoranthene derivative {structural formula (F1)} in the light emitting layer, the lower the light emission efficiency, or the larger the attenuation rate, but the chromaticity falls in the range of green, and the light emission efficiency is 8.72 Cd/A or more and the attenuation rate is 18% or less.

By contrast, in the organic electroluminescent element in Comparative Example 1 in which the light emitting layer is composed of coumarin 6 and Alq3, the attenuation rate was as high as 25%. Further, in the organic electroluminescent element in Comparative Example 2 in which the fluoranthene derivative [structural formula (F1)] was used as a guest and Alq3 was used as a host in the light emitting layer, the luminance, the light emission efficiency, and the power efficiency were individually low, as compared to those of the organic electroluminescent element in Example 1. In addition, the maximum emission wavelength was wide, which indicated that the light emission was nearly yellow.

### Example 5

An organic electroluminescent element of a top emission type was produced in accordance with substantially the same procedure as in Example 1 except that an ITO transparent electrode having a thickness of 12.5 nm was stacked on an Ag alloy (reflective layer) having a thickness of 190 nm to form an anode, that the thicknesses of the individual organic layers were adjusted to those shown below to form a resonance structure, and that the thickness of the codeposited layer of magnesium and silver constituting the upper layer of the cathode was changed to 12 nm to improve the transmittance. With respect to the thicknesses of the individual organic layers, the hole transport injection layer was 40 nm, the light emitting layer was 27 nm, and the electron transport layer was 15 nm in thickness.

The organic electroluminescent element in Example 5, in which the light emitting layer is composed of the fluoranthene derivative (FPB) and the arylanthracene derivative (ADN), was driven with a direct current at a current density of 12.5 mA/cm² in the same manner as in Examples 1 to 4. As a result, green light emission having a luminance of 2,580 (Cd/m²), a chromaticity of (0.285, 0.677), and a light emission peak of 533 nm was confirmed, and it has been confirmed that the chromaticity of green is improved due to the resonance structure, as compared to those in Examples 1 to 4. The driving voltage was 4.96 V, the light emission efficiency was 20.6 (Cd/A), and the power efficiency was 13.1 (lm/W). Particularly, by using an Ag alloy (reflective layer) having high reflectance in the anode, high current efficiency could be obtained. Further, it has been confirmed that the attenuation rate of the luminance after continuously driving the element at an initial luminance of 1,370 (Cd/m²) in a nitrogen gas stream for 1,000 hours is as very low as 9%. The results of the evaluation are also shown in the Table 1 above.

### Comparative Example 3

An organic electroluminescent element of a top emission type was produced in accordance with substantially the same procedure as in Example 5 except that, instead of the guest composed of the fluoranthene derivative of the structural formula (F1) in the light emitting layer, coumarin 6:3-(2-benzothiazolyl)-7-diethylaminocoumarin was used, and that, instead of the host composed of the arylanthracene derivative (ADN) of the structural formula (A1) in the light emitting layer, Alq3 was used. The guest concentration was 1% by volume.

The organic electroluminescent element in Comparative Example 3, in which the light emitting layer is composed of coumarin 6 and Alq3, was driven with a direct current at a current density of 12.5 mA/cm² in the same manner as mentioned above. As a result, green light emission having a luminance of 1,780 (Cd/m²), a chromaticity of (0.25, 0.68), and a light emission peak of 525 nm was confirmed. The driving voltage was 5.0 V, the light emission efficiency was 14.1 (Cd/A), and the power efficiency was 8.84 (lm/W). The attenuation rate of the luminance after continuously driving the element at an initial luminance of 1,310 (Cd/m²) in a nitrogen gas stream for 1,000 hours was as high as 23%. The results of the evaluation are also shown in the Table 1 above.

### Examples 6 to 13

Organic electroluminescent elements of a bottom emission type were individually produced in accordance with substantially the same procedure as in Example 1 except that the fluoranthene derivative as a guest in the light emitting layer was changed to compounds of the structural formulae shown in the Table 2 below. The guest concentration of the light emitting layer was the same as that in Example 1, i.e., 5% by volume.

### Example 14

An organic electroluminescent element of a transmission type was produced in accordance with substantially the same procedure as in Example 13 except that the host in the light emitting layer was changed to a compound of the structural formula (A12).

### Example 15

An organic electroluminescent element of a top emission type was produced in accordance with substantially the same procedure as in Example 10 except that an ITO transparent electrode having a thickness of 12.5 nm was stacked on an Ag alloy (reflective layer) having a thickness of 190 nm to form an anode, that the thicknesses of the individual organic layers were adjusted to those shown below to form a resonance structure, and that the thickness of the codeposited layer of magnesium and silver constituting the upper layer of the cathode was changed to 12 nm to improve the transmittance. With respect to the thicknesses of the individual organic layers, the hole transport injection layer was 40 nm, the light emitting layer was 27 nm, and the electron transport layer was 15 nm in thickness.

**Table 2**

| | Structural formula of guest | Structural formula of host | Luminance (Cd/m²) | Chromaticity | ELmx (nm) | Voltage (V) | Lightenrission efficiency (Cd/A) | Power efficiency (lm/W) | Attenuationrate after 100h |
|---|---|---|---|---|---|---|---|---|---|
| Example 1 | (F1) | (A1) | 2,210 | (0.358,0.598) | 532 | 5.33 | 17.68 | 10.42 | 10% |
| Example 6 | (F2) | Ditto | 1,890 | (0.366,0.595) | 532 | 6.04 | 15.12 | 7.86 | 8% |
| Example 7 | (F3) | Ditto | 1,850 | (0.359,0.604) | 533 | 5.66 | 14.80 | 8.21 | 9% |
| Example 8 | (F4) | Ditto | 1,660 | (0.400,0.572) | 541 | 5.30 | 13.28 | 9.43 | 13% |
| Example 9 | (F5) | Ditto | 1,860 | (0.359,0.604) | 533 | 5.70 | 14.88 | 8.21 | 9% |
| Example 10 | (F9) | Ditto | 1,970 | (0.331,0.619) | 526 | 5.80 | 15.76 | 8.53 | 7% |
| Example 11 | (F15) | Ditto | 839 | (0.266,0.572) | 508 | 5.99 | 6.72 | 3.52 | 17% |
| Example 12 | (F17) | Ditto | 950 | (0.259,0.621) | 514 | 5.71 | 7.60 | 4.18 | 20% |
| Example 13 | (F21) | Ditto | 1,470 | (0.329,0.601) | 519 | 5.81 | 11.76 | 6.35 | 18% |
| Example 14 | (F17) | (A12) | 1,030 | (0.328,0.606) | 522 | 5.59 | 8.24 | 4.63 | 19% |
| | | | | | | | | | |
| Example 15 | Resonance structure of (F9) in Example 10 | | 2,630 | (0.235,0.699) | 523 | 5.11 | 21.04 | 12.93 | *7% |

| | | | | | | | | | |
|---|---|---|---|---|---|---|---|---|---|
| * The value in Example 15 is an attenuation rate after 1,000 hours. | | | | | | | | | |

The results of Example 1 are also shown in the Table 2 above.

### Results of evaluation

With respect to each of the organic electroluminescent elements of a bottom emission type produced in Examples 6 to 15, evaluation was made as follows. Each element was driven with a direct current at 12.5 mA/cm² in the same manner as in Examples 1 to 5 to measure light emission properties, and the results are shown in the Table 2 above.

As can be seen from the results shown in Table 2, even in the organic electroluminescent element in which the light emitting layer is composed of the fluoranthene derivative of the structural formula corresponding to a specific example of the general formula (1) and the arylanthracene derivative (ADN){structural formula (A1) or structural formula (A12)}, light emission with high efficiency could be obtained, and the maximum emission wavelength confirmed that green light emission could be obtained.

Particularly, the organic electroluminescent element in Example 15, in which the light emitting layer is composed of the fluoranthene derivative (FPB) and the arylanthracene derivative (ADN), was driven with a direct current at a current density of 12.5 mA/cm² in the same manner as in Examples 6 to 14. As a result, green light emission having a luminance of 2,630 (Cd/m²), a chromaticity of (0.235, 0.699), and a light emission peak of 523 nm was confirmed. This chromaticity is particularly close to the standard of NTSC green light emission, i.e., (0.210, 0.710), which indicates that green with high purity was obtained. The driving voltage was 5.11 V, the light emission efficiency was 21.04 (Cd/A), and the power efficiency was 12.93 (lm/W). Particularly, by using an Ag alloy (reflective layer) having high reflectance in the anode, high current efficiency could be obtained. It has been confirmed that the attenuation rate of the luminance after continuously driving the element at an initial luminance of 1,370 (Cd/m²) in a nitrogen gas stream for 1,000 hours is as very low as 7%.

## Claims

1. An organic electroluminescent element having a light emitting layer sandwiched between an anode and a cathode, **characterized in that**:
the light emitting layer contains a fluoranthene derivative represented by the following general formula (1) and emits a green light: 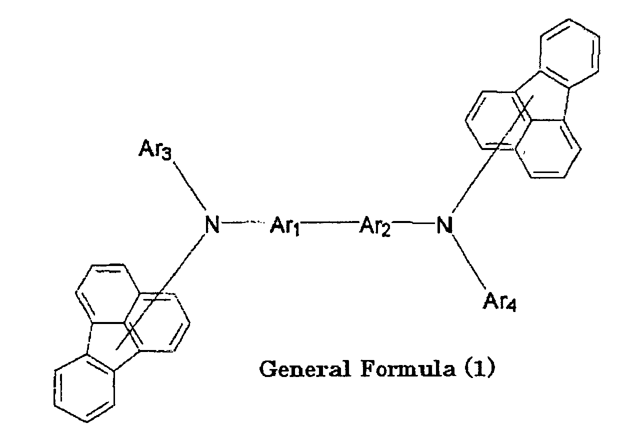
wherein in the general formula (1), each of two fluoranthenes may be independently substituted with hydrogen, an alkyl group having 6 or less carbon atoms, an alkoxy group having 6 or less carbon atoms, or an aryl group having 12 or less carbon atoms,
each of Ar₁ and Ar₂ independently represents an arylene group having 22 or less carbon atoms,
each of Ar₃ and Ar₄ independently represents an aryl group having 16 or less carbon atoms, and
in each aryl group and each arylene group, one hydrogen or a plurality of hydrogens may be replaced by an alkyl group or alkoxy group having 6 or less carbon atoms.

2. The organic electroluminescent element as described in claim 1,
**characterized in that**:
the fluoranthene derivative is represented by the following general formula (2): 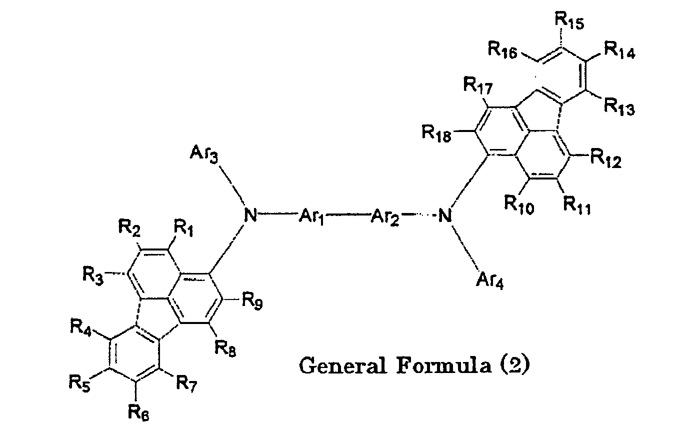
wherein in the general formula (2), each of substituents R₁ to R₁₈ in two fluoranthenes independently represents hydrogen, an alkyl group having 6 or less carbon atoms, an alkoxy group having 6 or less carbon atoms, or an aryl group having 12 or less carbon atoms, and
in each aryl group, one hydrogen or a plurality of hydrogens may be replaced by an alkyl group or alkoxy group having 6 or less carbon atoms.

3. The organic electroluminescent element as described in claim 1, **characterized in that**:
in the general formula (1), each of Ar₁ and Ar₂ independently represents an arylene group having 14 or less carbon atoms, and
in the general formula (1) each of Ar₃ and Ar₄ independently represents an aryl group having 14 or less carbon atoms.

4. The organic electroluminescent element as described in claim 3, **characterized in that**:
each of the aryl group and arylene group in the fluoranthene derivative is derived from any one of benzene, naphthalene, anthracene, and biphenyl.

5. The organic electroluminescent element as described in claim 1, **characterized in that**:
concentration of the fluoranthene derivative in the light emitting layer is less than 50% by volume.

6. The organic electroluminescent element as described in claim 1, **characterized in that**:
the light emitting layer contains an organic material having a fluorescence spectrum overlapping the absorption spectrum of the fluoranthene derivative.

7. The organic electroluminescent element as described in claim 6, **characterized in that**:
the organic material having a fluorescence spectrum overlapping the absorption spectrum of the fluoranthene derivative comprises an arylanthracene derivative.

8. The organic electroluminescent element as described in claim 7, **characterized in that**:
the arylanthracene derivative is represented by the following general formula (3): 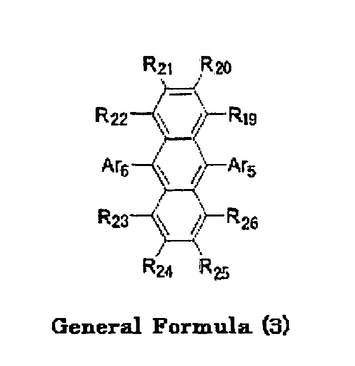
wherein in the general formula (3), each of R₁₉ to R₂₆ independently represents hydrogen, or an alkyl group or alkoxy group having 6 or less carbon atoms,
each of Ar₅ and Ar₆ independently represents an aryl group or ring assembly aryl group having 60 or less carbon atoms, and
in each aryl group or each ring assembly arylene group, one hydrogen or a plurality of hydrogens may be replaced by an alkyl group or alkoxy group having 12 or less carbon atoms, or a substituted or unsubstituted ethenyl group having 60 carbon atoms or less.

9. A display apparatus having a plurality of organic electroluminescent elements having a light emitting layer sandwiched between an anode and a cathode and being arranged on a substrate, **characterized in that**:
the light emitting layer contains a fluoranthene derivative represented by the following general formula (1): 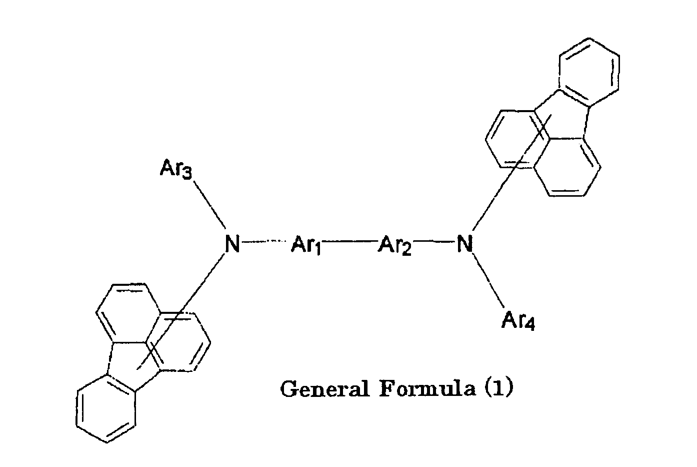
wherein in the general formula (1), each of two fluoranthenes may be independently substituted with hydrogen, an alkyl group having 6 or less carbon atoms, an alkoxy group having 6 or less carbon atoms, or an aryl group having 12 or less carbon atoms,
each of Ar₁ and Ar₂ independently represents an arylene group having 22 or less carbon atoms,
each of Ar₃ and Ar₄ independently represents an aryl group having 16 or less carbon atoms, and
in each aryl group and each arylene group, one hydrogen or a plurality of hydrogens may be replaced by an alkyl group or alkoxy group having 6 or less carbon atoms.

10. The display apparatus as described in claim 9, **characterized in that**:
the fluoranthene derivative is represented by the following general formula (2): 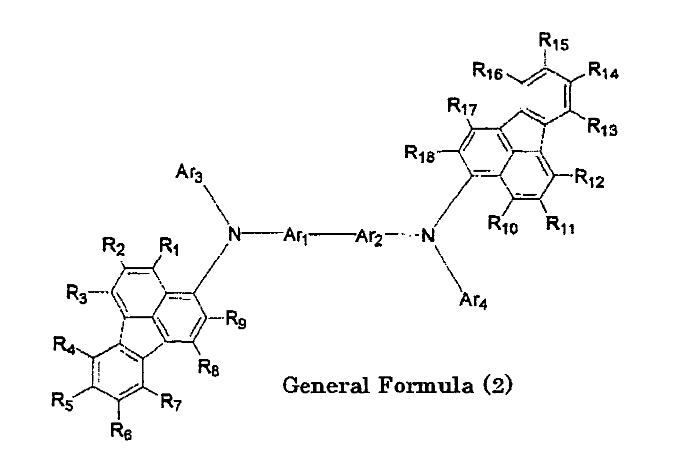
wherein in the general formula (2), each of substituents R₁ to R₁₈ in two fluoranthenes independently represents hydrogen, an alkyl group having 6 or less carbon atoms, an alkoxy group having 6 or less carbon atoms, or an aryl group having 12 or less carbon atoms, and
in each aryl group, one hydrogen or a plurality of hydrogens may be replaced by an alkyl group or alkoxy group having 6 or less carbon atoms.

11. The display apparatus as described in claim 9, **characterized in that**:
in the general formula (1), each of Ar₁ and Ar₂ independently represents an arylene group having 14 or less carbon atoms, and
in the general formula (1) each of Ar₃ and Ar₄ independently represents an aryl group having 14 or less carbon atoms.

12. The display apparatus as described in claim 11, **characterized in that**:
each of the aryl group and arylene group in the fluoranthene derivative is derived from any one of benzene, naphthalene, anthracene, and biphenyl.

13. The display apparatus as described in claim 9, **characterized in that**:
concentration of the fluoranthene derivative in the light emitting layer is less than 50% by volume.

14. The display apparatus as described in claim 9, **characterized in that**:
the light emitting layer contains an organic material having a fluorescence spectrum overlapping the absorption spectrum of the fluoranthene derivative.

15. The display apparatus as described in claim 14, **characterized in that**:
the organic material having a fluorescence spectrum overlapping the absorption spectrum of the fluoranthene derivative comprises an arylanthracene derivative.

16. The display apparatus as described in claim 15, **characterized in that**:
the arylanthracene derivative is represented by the following general formula (3): 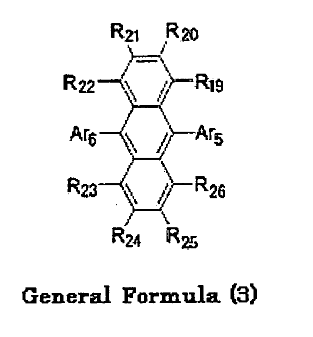
wherein in the general formula (3), each of R₁₉ to R₂₆ independently represents hydrogen, or an alkyl group or alkoxy group having 6 or less carbon atoms,
each of Ar₅ and Ar₆ independently represents an aryl group or ring assembly aryl group having 60 or less carbon atoms, and
in each aryl group or each ring assembly arylene group, one hydrogen or a plurality of hydrogens may be replaced by an alkyl group or alkoxy group having 12 or less carbon atoms, or a substituted or unsubstituted ethenyl group having 60 carbon atoms or less.

17. The display apparatus as described in claim 9, **characterized in that**:
the organic electroluminescent element is formed as a green light emitting element in a part of a plurality of pixels.
